# DEMANDE DE BREVET EUROPEEN

(11) **EP 4 567 527 A1**
(43) Date de publication de la demande: **11.06.2025**
(21) Numéro de dépôt: 23214739.7
(22) Date de dépôt: 06.12.2023
(51) Int. Cl.: G04B 17/06, B28D 5/02, B81C 1/00, G04D 3/00, G04B 1/14, G04B 13/02, G04B 15/14

(54) **PROCÉDÉ DE FABRICATION DE COMPOSANTS HORLOGERS EN SILICIUM**

(71) Demandeur: Richemont International S.A., 1752 Villars-sur-Glâne (CH)
(72) Inventeur: MONTINARO, Enrica, 3012 Bern (CH)
(74) Mandataire: Novagraaf International SA

(57) **Abrégé**

Un procédé de fabrication d'une pluralité de composants horlogers (90) dans une plaquette est décrit. Le procédé comprend les étapes suivantes : (a) se doter d'une plaquette (10, 110), ayant un côté inférieur (10A, 110A) et un côté supérieur (10B, 110B), l'épaisseur initiale de la plaquette (e₃₀, e110) étant plus importante que l'épaisseur maximale des composants horlogers (e₉₀) à fabriquer, ladite plaquette comprenant au moins une couche en silicium (30, 130) dans laquelle les composants horlogers (90) sont formés ; (b) former les composants horlogers (90) en gravant des motifs dans la couche en silicium (30, 30', 130, 130') depuis le côté supérieur (10B, 110B) de la plaquette (10, 110) ; et (c) effectuer un nivellement mécanique depuis le côté inférieur (10A, 110A) de la plaquette (10, 110) pour éliminer une partie de la plaquette (10, 110) par un amincissement de l'épaisseur de ladite plaquette (10, 110).

## Description

### Domaine technique

L'invention concerne un procédé de fabrication de composants horlogers en silicium. Un tel procédé de fabrication comprend généralement des étapes de microfabrication incluant la lithographie et la gravure d'une plaquette comprenant au moins une couche en silicium ainsi que des étapes de fabrication postérieures à la gravure telles que la libération des composants et le lissage des surfaces gravées.

### Etat de la technique

La fabrication de composants horlogers en silicium tels que, mais de façon non limitative, des ressorts spiraux, des cames, des ressorts, des cliquets, des roues et des ancres en utilisant des procédés de microfabrication est bien connue. Avantageusement, plusieurs centaines de composants horlogers peuvent être fabriqués sur une seule plaquette (en anglais « wafer ») en utilisant ces technologies. Il est, par exemple, connu de réaliser une pluralité de résonateurs en silicium avec une très haute précision en utilisant des procédés de photolithographie et d'usinage par gravure dans une plaquette en silicium. Les procédés de réalisation de ces composants horlogers utilisent généralement des plaquettes de silicium monocristallin, mais des plaquettes en silicium polycristallin ou silicium amorphe sont également utilisables.

Le silicium est un matériau diamagnétique, et son utilisation pour la fabrication de composants horlogers, et notamment pour les composants de l'organe régulateur d'un mouvement de montre mécanique, est avantageuse car aucun effet rémanent n'est observé après l'exposition de ce matériau aux champs magnétiques. De plus, les variations du module d'Young d'un composant horloger en silicium en fonction de la température peuvent être compensées par l'ajout d'une couche d'oxyde sur le composant. Quand les composants horlogers sont réalisés à partir d'une plaquette en silicium monocristallin, l'une quelconque des trois orientations cristallines <100>, <110> ou <111> peut être utilisée.

Les plaquettes de silicium sont proposées sous forme de couche simple sans couche de support, par exemple des plaquettes simples de type SSP (« Single Side polished » en anglais) ou de type DSP (« Dual Side Polished » en anglais). Le document EP3495894 décrit un procédé de fabrication de composants horlogers en silicium utilisant une telle plaquette comprenant une couche simple en silicium sans couche de support. Selon ce document, la plaquette simple a une épaisseur sensiblement égale à l'épaisseur maximale des composants horlogers à fabriquer, et pour former les composants horlogers, on effectue une étape de gravure dans toute l'épaisseur de la plaquette, la totalité du matériau du composant présent dans la plaquette étant ainsi utilisée pour former les composants horlogers, sans fonction de support dans la plaquette. Après leur formation, les composants horlogers ne sont supportés structurellement que par des ponts de liaison fins qui les maintiennent attachés aux parties subsistantes de la couche simple en silicium, et il est possible d'effectuer des étapes de fabrication subséquentes sur la quasi-totalité de la surface externe des composants sans qu'il soit nécessaire d'effectuer une étape de libération des composants auparavant. Cependant, dans le procédé de fabrication du document EP3495894, l'étape de gravure est délicate car elle a lieu dans une plaquette relativement mince, et donc fragile, sans aucun support.

Selon d'autres approches, des plaquettes SOI (« silicon-on-insulator » en anglais) sont aussi souvent utilisées pour la fabrication de composants horlogers. Une plaquette SOI comprend une couche de travail en silicium (la couche « device » en anglais) dans laquelle les composants horlogers sont fabriqués, une couche de support typiquement en silicium qui sert de substrat ou de support lors de la fabrication des composants (la couche « handle » en anglais), et une couche d'oxyde de silicium enterrée qui se trouve entre les deux couches de silicium (la couche « buried oxide layer » ou BOX en anglais). La surface de la couche de travail et éventuellement la surface de la couche de support peuvent également être polies pour faciliter des étapes de lithographie sur ces couches.

Après les étapes de lithographie et de gravure pour initialement former les composants horlogers dans la couche de travail d'un wafer SOI, ces derniers sont normalement libérés de la couche de support et de la couche d'oxyde enterrée de la plaquette SOI en utilisant des techniques de microfabrication afin de faciliter des étapes de fabrication subséquentes. De cette manière, après la libération, les composants horlogers ne sont supportés structurellement que par des ponts de liaison fins qui les maintiennent attachés aux parties subsistantes de la couche de travail, ce qui permet notamment d'effectuer les étapes de fabrication subséquentes sur l'ensemble de la surface externe des composants de la plaquette. Les étapes subséquentes peuvent notamment comprendre des étapes d'oxydation et de désoxydation pour le lissage des surfaces des composants. Les étapes subséquentes peuvent également comprendre des étapes d'oxydation et de désoxydation pour ajuster les dimensions des composants (par exemple afin de corriger la raideur quand les composants sont des spiraux ou des résonateurs) et/ou des étapes d'oxydation pour former une couche externe d'oxyde de silicium sur les composants aux fins d'une compensation thermique et/ou d'un renforcement mécanique.

La libération des composants horlogers sur une plaquette SOI peut être réalisée par différentes méthodes. Selon une approche décrite dans le document WO2019180596, après la formation des composants, la couche de travail (ou une partie de cette couche comprenant les composants) est séparée de la couche de support. Cette séparation peut être facilitée par la gravure d'une saignée entourant les composants ainsi que des ouvertures dans la couche de travail. Par la suite, la couche d'oxyde enterrée est gravée avec de la vapeur d'acide fluorhydrique (HF) qui passe au travers des ouvertures formées dans la couche de travail, et la partie de la couche de travail définie par la saignée est séparée de la couche de support de la plaquette SOI. Une autre approche de libération est décrite dans les documents de brevet JP2017219520 et WO2019180177. Selon cette approche, après la formation des composants par gravure, on fait croître une couche d'oxyde de silicium en surface du silicium. Cette couche d'oxyde sert de protection pour les composants formés. Par la suite, on réalise une photolithographie et une gravure pour exposer le silicium de la couche de support et graver la couche de support en l'attaquant par la face opposée aux composants, ce qui supprime la couche de support en dessous des composants. Pour terminer la libération selon cette alternative, on élimine la couche enterrée du wafer SOI en dessous des composants ainsi que la couche de protection sur les composants.

Ces approches de libération des composants horlogers dans une plaquette SOI impliquent des étapes de microfabrication supplémentaires dans une salle blanche et sont par conséquent relativement longues, complexes et chères. Il serait alors souhaitable d'avoir un procédé de fabrication de composants horlogers en silicium plus simple, plus rapide et moins couteux.

### Bref résumé de l'invention

Un but de la présente invention est de proposer un procédé de fabrication d'une pluralité de composants horlogers sur une plaquette simple ou du type SOI, qui permet d'éviter ou de pallier les inconvénients ci-dessus, ou en tout cas d'offrir un meilleur compromis entre ces inconvénients.

En particulier, ce but est au moins partiellement atteint en proposant un nouveau procédé de fabrication selon lequel les composants horlogers sont initialement formés dans une plaquette plus épaisse que l'épaisseur maximale des composant horlogers, et une étape de nivellement mécanique est réalisée pour amincir la plaquette depuis son côté inférieur. La formation des composants dans une couche en silicium de la plaquette a lieu dans une plaquette suffisamment épaisse et solide pour faciliter les différentes étapes de microfabrication, et par la suite la libération des composants dans la plaquette est réalisée par une étape de nivellement mécanique qui est simple, rapide et économique.

Ainsi, selon un aspect, la présente invention concerne un procédé de fabrication d'une pluralité de composants horlogers dans une plaquette comprenant les étapes suivantes : (a) se doter d'une plaquette, ayant un côté inférieur, un côté supérieur et une épaisseur initiale, l'épaisseur initiale de la plaquette étant plus importante qu'une épaisseur maximale des composants horlogers à fabriquer, ladite plaquette comprenant au moins une couche en silicium dans laquelle les composants horlogers seront formés ; (b) former les composants horlogers en gravant des motifs dans la couche en silicium depuis le côté supérieur de la plaquette; et (c) effectuer un nivellement mécanique depuis le côté inferieur de la plaquette pour éliminer une partie de la plaquette par un amincissement de l'épaisseur de ladite plaquette.

Dans un mode de réalisation la plaquette comprend une couche simple en silicium sans couche de support, la couche simple ayant une épaisseur qui est plus importante que l'épaisseur maximale des composants horlogers, et dans lequel le nivellement mécanique à l'étape (c) élimine une partie de la couche simple. Dans ce cas, après le nivellement mécanique à l'étape (c), l'épaisseur de la couche simple est de préférence sensiblement égale à l'épaisseur maximale des composants horlogers, et les motifs gravés dans la couche simple ne s'étendent pas de préférence sur toute l'épaisseur de la couche simple. Les motifs peuvent être séparés par des tranchées ayant une profondeur plus importante que l'épaisseur maximum des composants horlogers. Autrement dit, l'étape (b) peut comprendre la formation de tranchées séparant les motifs et ayant une profondeur plus importante que l'épaisseur maximale des composants horlogers finaux.

Dans un autre mode de réalisation, la plaquette est une plaquette de type SOI comprenant une couche de support, une couche de travail en silicium dans laquelle les composants horlogers sont formés, et une couche d'oxyde enterrée (de préférence en oxyde de silicium) séparant la couche de support de la couche de travail. Dan ce cas, le nivellement mécanique à l'étape (c) élimine de préférence au moins l'ensemble de la couche de support de la plaquette. La couche de travail peut avoir une épaisseur qui est sensiblement égale à l'épaisseur maximale des composants horlogers, et dans un tel cas les motifs gravés dans la couche de travail s'étendent sur toute son épaisseur. Alternativement, la couche de travail peut avoir une épaisseur qui est plus importante que l'épaisseur maximale des composants horlogers, et les motifs peuvent être séparés par des tranchées qui ont une profondeur plus importante que l'épaisseur maximum des composants horlogers. Dans ce cas, le nivellement mécanique à l'étape (c) élimine une partie de la couche de travail, et après cette étape (c) l'épaisseur de la couche de travail est sensiblement égale à l'épaisseur maximale des composants horlogers. Autrement dit, l'étape (b) peut comprendre une étape de formation de tranchées séparant les motifs et ayant une profondeur plus importante que l'épaisseur maximale des composants horlogers finaux, et l'étape (c) peut être effectuée de sorte que l'épaisseur finale de la couche de travail soit inférieure à la profondeur initiale des tranchées séparant les motifs.

Selon différents modes de réalisation, une couche d'oxyde de silicium peut être formée sur au moins une partie des surfaces des composants horlogers avant le nivellement mécanique de l'étape (c) et/ou une couche de résine peut être formée sur au moins une partie des surfaces des composants horlogers avant cette étape (c). Autrement dit, le procédé peut comprendre une étape de formation d'une couche d'oxyde de silicium sur au moins une partie des surfaces des composants horlogers avant le nivellement mécanique de l'étape (c), et/ou une étape de formation d'une couche de résine sur au moins une partie des surfaces des composants horlogers (incluant sur une couche d'oxyde de silicium précédemment déposée sur ces surfaces) avant le nivellement mécanique de l'étape (c).

Avantageusement, on peut réaliser le nivellement mécanique à l'étape (c) avec un dispositif de meulage, mais alternativement on peut utiliser des moyens de polissage, de sablage, de rectification et/ou de découpe. Un tel dispositif de meulage peut comprendre un support sur lequel la plaquette est destinée à être montée et une roue de meulage portant des organes d'abrasion, le support et la roue étant mobiles en rotation l'un par rapport à l'autre. Dans ce cas, l'étape (c) de nivellement mécanique comprend les étapes de monter la plaquette dans le dispositif de meulage en mettant une surface supérieure de la plaquette contre le support et de mettre la roue et/ou le support en rotation afin que les organes d'abrasion de la roue agissent de manière contrôlée contre la surface de la plaquette depuis son côté inferieur et/ou effectuent une action abrasive contre la surface de la plaquette depuis son côté inferieur.

Un ruban adhésif sensible à la lumière ultraviolette peut être appliqué sur une surface supérieure de la plaquette avant l'étape (c) de nivellement mécanique, et on peut par la suite irradier la surface supérieure de la plaquette avec la lumière ultraviolette après l'étape (c) de nivellement mécanique afin d'enlever le ruban adhésif.

Par ailleurs, après la formation des composants horlogers à l'étape (b), les composants horlogers sont de préférence supportés structurellement par des ponts de liaison qui les maintiennent attachés aux parties subsistantes de la couche en silicium, ces ponts de liaison ayant une largeur d'au moins 5 µm. Autrement dit, le procédé peut comprendre une étape de formation, pour chaque composant horloger, d'au moins un pont de liaison ayant une telle largeur avec la plaquette.

D'autres caractéristiques avantageuses et privilégiées du procédé de fabrication sont précisées dans la description et les sous-revendications ci-dessous.

### Brève description des figures

Des exemples de mise en oeuvre de l'invention sont indiqués dans la description illustrée par les figures annexées dans lesquelles :
- Les figures 1a-1p illustrent schématiquement une série d'étapes de fabrication d'un composant horloger dans une plaquette simple selon un premier mode de réalisation ;
- Les figures 2a-2p illustrent schématiquement une série d'étapes de fabrication d'un composant horloger dans une plaquette SOI selon un second mode de réalisation ;
- La figure 3 illustre un exemple d'un dispositif de meulage permettant le nivellement mécanique de la plaquette de la figure 1 ou de la figure 2 ;
- Les figures 4 et 4A sont des vues de dessus de la plaquette simple de la figure 1 ou de la couche de travail de la plaquette SOI de la figure 2 selon un mode de réalisation ; et
- La figure 5 est une vue en section selon la ligne V-V de la figure 4.

### Exemples de mode de réalisation de l'invention

Dans tout ce qui suit, les orientations sont définies en fonction des orientations des figures. En particulier, les termes comme « supérieur », « inférieur », « gauche », « droit », « dessus », « dessous », « vers l'avant » et « vers l'arrière » s'entendent généralement par rapport au sens de représentation des figures. Les figures sont schématiques et peuvent présenter des proportions et/ou des aspects différents de la réalité même au sein d'une même figure, mais illustrent à tout le moins le déroulement et/ou les étapes des procédés décrits.

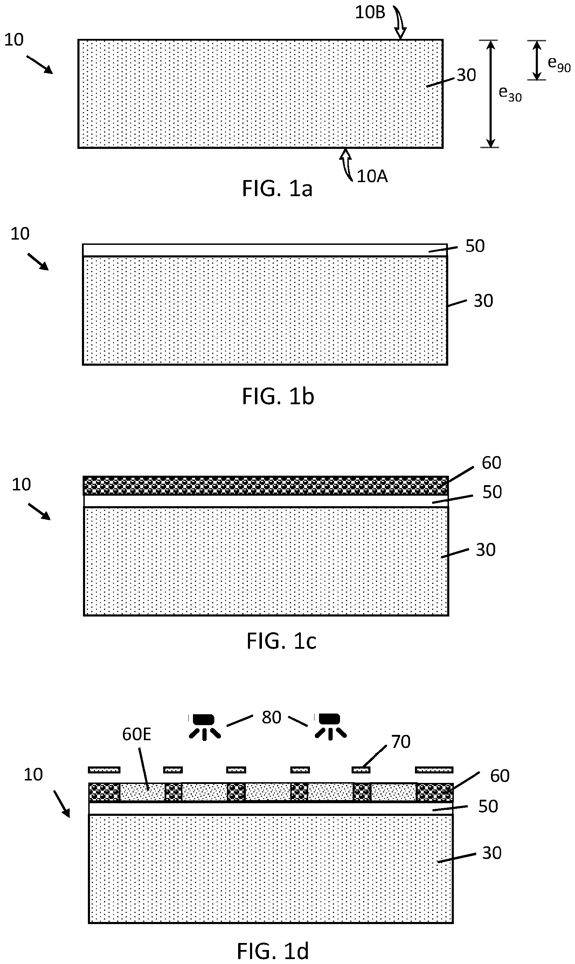

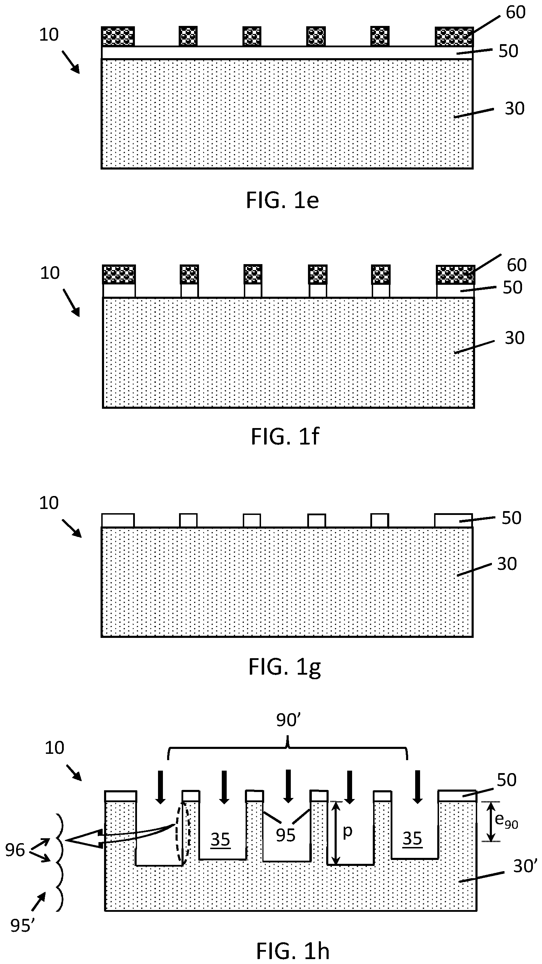

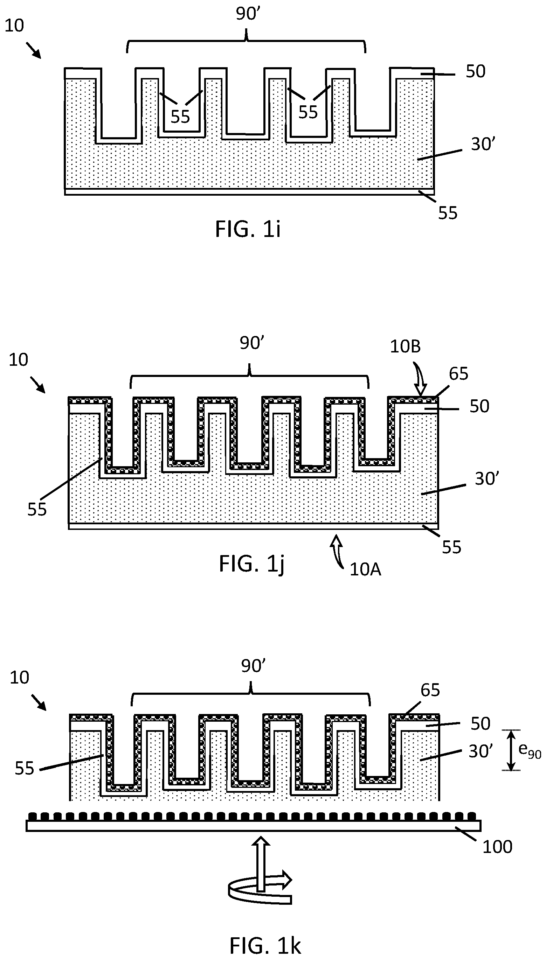

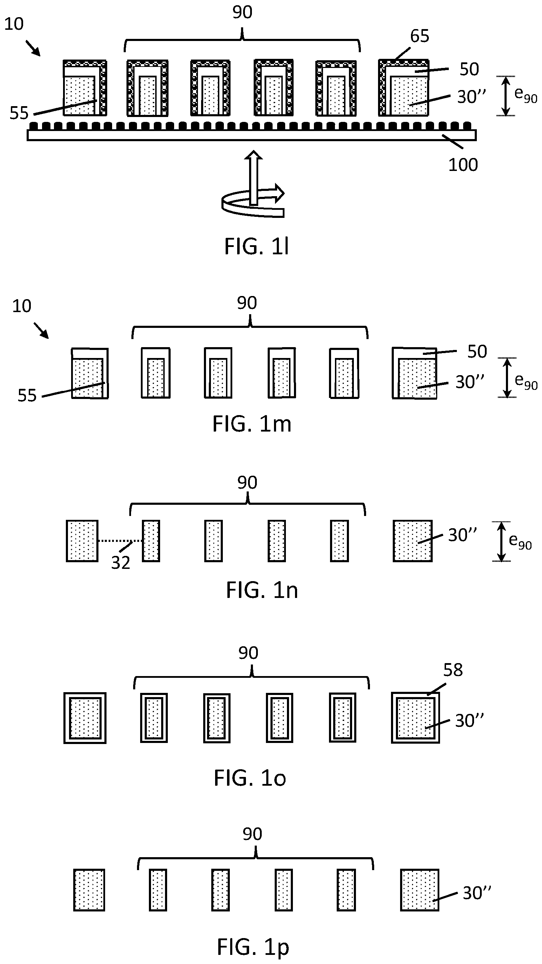

Les figures 1a-1p illustrent une série d'étapes de fabrication schématiques d'un composant horloger dans une plaquette simple 10 selon un premier mode de réalisation de l'invention. Bien entendu, plusieurs composants horlogers peuvent être fabriqués dans la plaquette 10 en même temps, mais les vues de la figure 1 sont isolées sur un seul composant pour des raisons de simplicité. Le procédé commence avec une plaquette simple 10 illustrée à la figure 1a, cette plaquette comprenant une couche simple 30 en silicium sans couche de support. Dans ce mode de réalisation, la couche simple 30 (voire la plaquette 10) a une épaisseur initiale e₃₀ qui est plus importante que l'épaisseur maximale e₉₀ des composants horlogers à former. Le dessin n'est pas à l'échelle, mais à titre d'exemple, la couche simple 30 peut avoir une épaisseur initiale e₃₀ de 150 µm - 500 µm, et de préférence de 200 µm - 300 µm. Dans un exemple, la couche simple 30 a une épaisseur e₃₀ de 250 µm. Pour sa part, l'épaisseur maximale e₉₀ des composants horlogers peut varier, mais dans un exemple elle est égale à 120 µm. En général, on peut avoir une tolérance d'au moins ± 2 µm autour de cette épaisseur ciblée e₉₀, car l'épaisseur finale des composants horlogers ne constitue pas typiquement une caractéristique critique dans leur performance. La couche simple 30 peut être en silicium monocristallin avec une orientation cristalline quelconque, en silicium polycristallin, ou en silicium amorphe, et elle peut être dopés type N ou type P. L'utilisation d'un silicium fortement dopé peut être avantageuse pour la fabrication des résonateurs car, par exemple, on constate une déformation moindre de la matière dopée lors de l'oxydation thermique sous certaines conditions. La plaquette 10 comprend un côté inférieur 10A, et c'est depuis ce côté que la plaquette 10 repose normalement sur des équipements lors des différentes étapes de microfabrication. La plaquette 10 comprend également un côté supérieur 10B, et c'est depuis ce côté que les étapes de microfabrication pour former les composants horlogers sont généralement effectuées.

Lors des différentes étapes de fabrication décrites ci-dessous (incluant la lithographie et la gravure), la couche simple 30 peut être montée sur un support plan (non illustré), mais cela n'est pas indispensable puisque la couche simple 30 a quand même une épaisseur e₃₀ qui est plus importante que l'épaisseur maximale e₉₀ des composants horlogers à former. Cependant, si c'est utile, un tel support peut être par exemple en métal, en céramique, en verre ou en quartz, et de préférence le support est plus épais et/ou plus rigide que la couche simple 30 afin qu'il est plus facile à le manipuler. Par ailleurs, pour au moins certaines des étapes, la couche simple peut également être liée temporairement à un tel support par des moyens adhésifs (par exemple de la colle ou un ruban adhésif appliqué à la périphérie de la couche) ou un système d'aspiration sous vide.

Dans la figure 1b, une étape de lithographie commence avec la formation d'une couche d'oxyde de silicium 50 sur la surface supérieure de la couche simple 30. Par « lithographie », on entend l'ensemble des opérations permettant de transférer une image ou un motif sur ou au-dessus de la plaquette 10 vers cette dernière. La couche d'oxyde 50 peut par exemple avoir une épaisseur comprise entre 0.4 - 6 µm, et elle peut être formée par oxydation thermique ou alternativement par un dépôt de type PVD, CVD, ou ALD. Si la couche d'oxyde 50 est formée par un procédé de dépôt directionnel tel que le CVD ou le PVD, l'oxyde se forme uniquement sur la surface supérieure de la couche simple 30, tel qu'illustré à la figure 1b. Alternativement, si la couche d'oxyde 50 est formée par oxydation thermique, on remarque que l'oxyde 50 se forme généralement en même temps sur la surface inférieure de la couche simple 30 ou encore un second dépôt directionnel de type CVD ou PVD peut être effectué sur cette surface. De manière générale, la formation de la couche d'oxyde 50 avant le dépôt d'une couche de résine (voir la figure 1c) permet de déposer une couche de résine relativement fine et uniforme avec une bonne homogénéité de surface et ainsi d'optimiser la gravure subséquente de motifs fins et profonds dans la couche simple 30. Cependant, dans d'autres modes de réalisation, il est également possible de réaliser une étape de lithographie sans la couche d'oxyde, notamment en utilisant une résine photosensible plus épaisse.

A la figure 1c, la couche d'oxyde 50 est recouverte d'une couche de résine 60, qui est typiquement une résine photosensible de type positif ou négatif. Cette couche de résine peut avoir une épaisseur comprise entre 0.5 - 12 µm, à titre purement illustratif. Par la suite, dans la figure 1d, la couche de résine 60 est structurée de préférence en utilisant une étape de photolithographie avec une source de lumière ultraviolette 80 ainsi que, par exemple, un masque d'exposition 70 tel qu'un photomasque. Un système de stepper et réticule peut également être utilisé pour l'étape de photolithographie. Dans l'exemple illustré, la couche 60 comprend une résine photosensible de type positif dont les parties 60E de la résine qui sont exposées à la lumière deviennent solubles dans un révélateur et les parties non exposées restent insolubles. Selon d'autres modes de réalisation, la résine peut être structurée par un faisceau laser ou d'électrons.

Dans la figure 1e, la couche de résine 60 est ouverte après avoir été développée par un révélateur, notamment un solvant qui élimine les parties exposées 60E de la résine par voie chimique. Ensuite, à la figure 1f, les parties de la couche d'oxyde 50 qui se trouvaient en dessous des parties exposées 60E de la résine sont aussi retirées de la surface de la couche simple 30, par exemple en employant une gravure plasma sélective avec les gaz CH₄/O₂. L'utilisation d'une technique de gravure directionnelle est généralement privilégiée lors de cette étape car elle est plus précise, mais alternativement une gravure à base de vapeur d'acide fluorhydrique (HF) peut aussi être utilisée.

A l'étape illustrée à la figure 1g, la partie restante de la couche de résine 60 est éliminée et ensuite, à l'étape de la figure 1h, des motifs séparés par des tranchées 35 sont gravés dans la couche simple 30 au travers de la couche 50 structurée pour former une version brute, autrement dit une ébauche, du composant horloger 90 dans une couche simple structurée 30'. Dans le mode de réalisation illustré, les motifs gravés ne s'étendent pas sur toute l'épaisseur e₃₀ de la couche simple structurée 30', mais les tranchées 35 formées dans cette couche ont toutes une profondeur p plus importante que l'épaisseur maximum e₉₀ des composants horlogers. Par ailleurs, la profondeur des tranchées 35 formées dans la couche simple structurée 30' peut varier légèrement entre elles, puisqu'il n'y a pas de couche d'arrêt pour arrêter la gravure uniformément. Il est également possible que les motifs gravés et les tranchées 35 s'étendent sur toute l'épaisseur e₃₀ de la couche simple.

La gravure à l'étape de la figure 1h peut notamment être effectuée par une technique de gravure ionique réactive profonde (également connue sous l'acronyme DRIE pour « Deep Reactive Ion Etching » en anglais). La gravure DRIE permet d'usiner des trous et des tranchées profondes dans la couche simple avec un rapport largeur/hauteur important, ce qui est bien adapté pour des composants micromécaniques comme des composants horlogers. Alternativement, la structuration de la couche simple peut être réalisée par d'autres technologies de gravure telles qu'une opération de gravure humide/chimique anisotrope, par exemple en utilisant un bain d'hydroxyde de potassium (KOH) ou d'hydroxyde de tétraméthylammonium (TMAH). Une structuration par gravure humide/chimique peut notamment être plus rapide qu'une gravure ionique réactive profonde, mais la résolution dimensionnelle des structures gravées est généralement moins bonne. Si une opération de gravure humide/chimique anisotrope est employée, la couche d'oxyde 50 n'est normalement pas formée sur la surface supérieure de la couche simple 30 avant le dépôt de la résine 60 sur cette surface.

Il est également possible pour la partie restante de la couche de résine 60 d'être toujours présente lors de l'étape de gravure (DRIE ou autre) de la couche simple 30. Cette partie restante de la couche de résine peut être retirée après la gravure, et dans ce cas, la couche simple 30 est gravée au travers des deux couches 50, 60 structurées (ou seulement à travers la couche 60 structurée si une couche d'oxyde 50 n'est pas présente). A titre d'exemple, une résine positive peut être retirée par des solvants de type acétone ou diméthylsulfoxyde (DMSO) ou avec un plasma C₂ soit avant soit après l'étape de gravure. Pour une résine négative comme le SU-8, un plasma CF₄/O₂ peut être employé pour son retrait.

Par la suite, à la figure 1i, une couche d'oxyde 55 de silicium (SiO₂) est de préférence formée sur au moins une partie des surfaces des flancs 95 du composant horloger et de préférence sur l'ensemble de chacune de ses surfaces. La couche d'oxyde 55 peut être formée par un dépôt de type PVD, CVD, ou ALD, mais de préférence elle est formée par oxydation thermique, et dans ce cas la couche d'oxyde 55 est formée également sur tout le silicium exposé de la plaquette 10, incluant la surface inférieure de la couche simple structurée 30'. L'épaisseur de cette couche d'oxyde 55 peut varier mais de préférence elle est d'au moins 0.05 µm. Par ailleurs, la couche d'oxyde 55 rejoint la couche d'oxyde 50 déjà présente sur la surface supérieure du composant horloger 90, et cette dernière couche peut aussi devenir plus épaisse si le dépôt de cette étape est effectué par oxydation thermique. Selon une variante, la couche d'oxyde 50 peut être éliminée après l'étape de gravure à la figure 1h, et dans ce cas la couche d'oxyde 55 se forme également sur la surface supérieure des composants horlogers 90 lors de l'étape de la figure 1i.

A une étape suivante illustrée à la figure 1j, la surface supérieure de la couche simple structurée 30' et donc les composants 90 formés dans cette couche (qui sont déjà recouverts par les couches d'oxydes 50, 55) sont optionnellement recouverts, du moins en partie, d'une couche de résine 65. Le dépôt de la résine 65 est de préférence effectué par un revêtement obtenu par pulvérisation (en anglais « spray coating ») mais il peut également être réalisé par un trempage (an anglais « dip coating »), par une enduction par centrifugation (en anglais « spin coating »), ou par un dépôt sous vide avec de la poudre. Selon une variante, on peut sauter ou éviter la formation de l'oxyde 55 à l'étape de la figure 1i , et la résine 65 peut être déposée directement sur la couche simple (avec ou sans la couche d'oxyde 50) après l'étape de la figure 1h.

Le procédé de fabrication continue aux figures 1k et 1l avec une étape de nivellement mécanique qui sert à éliminer une partie de la plaquette 10 par un amincissement (voire une réduction) de l'épaisseur de la plaquette 10 depuis son côté inferieur 10A. Dans ce mode de réalisation, l'étape de nivellement mécanique est notamment destinée à éliminer une partie de la couche simple structurée 30' et donc à amincir cette couche afin que son épaisseur soit sensiblement égale à l'épaisseur maximale e₉₀ des composants horlogers. Comme décrit en plus de détails ci-dessous, ce nivellement mécanique est effectué depuis le côté inférieur 10A de la plaquette 10 et peut par exemple être réalisé par un dispositif de meulage (en anglais « grinding ») 100 qui sert à réduire l'épaisseur de la couche simple structurée 30' de manière uniforme et contrôlée et, par exemple, avec une variation d'épaisseur de ± 1 µm. Alternativement, des moyens de polissage, de sablage, de rectification et/ou de découpe (par exemple avec un outil diamant ou corindon) peuvent être utilisés pour effectuer le nivellement mécanique. La figure 1k montre l'étape de nivellement mécanique en cours où le dispositif de meulage a déjà éliminé une partie de l'épaisseur à enlever de la couche simple structurée 30' ainsi que toute la couche d'oxyde 55 sur la surface inférieure de cette couche si elle est présente. Dans la figure 1l, l'étape de nivellement mécanique prend fin quand l'épaisseur de la couche simple structurée est sensiblement égale à l'épaisseur maximale e₉₀ des composants horlogers. A la fin de l'étape de nivellement mécanique, il en résulte une couche simple structurée amincie 30" dans laquelle les surfaces inferieures des composants horlogers 90 sont libres et leur épaisseur correspond sensiblement à l'épaisseur maximale voulue e₉₀ des composants.

Selon une variante, l'étape de nivellement mécanique peut avoir lieu immédiatement après l'étape de gravure de la figure 1h, mais de préférence les couches 55 et/ou 65 sont formées après la gravure afin de protéger les composants horlogers lors de l'étape de nivellement mécanique. Quand ces couches sont formées tel que décrit ci-dessus en lien avec les figures 1i et 1j, la couche de résine 65 est éliminée après l'étape de nivellement mécanique comme illustré à la figure 1m et par la suite, à la figure 1n, on effectue une désoxydation pour éliminer les couches d'oxydes 50 et 55 autour du composant 90. Cette étape de désoxydation est de préférence réalisée par une gravure par voie humide ou en phase vapeur à base d'acide fluorhydrique (HF).

La formation de la couche d'oxyde 55 par oxydation thermique à la figure 1i peut aussi faire partie d'une étape de lissage des composants horlogers 90. En fait, après l'étape de gravure de la couche simple pour former les motifs des composants horlogers 90, il est connu que les surfaces des flancs 95 de ces motifs structurés possèdent une rugosité relativement importante. Dans le cadre d'une gravure type DRIE, cette rugosité se manifeste sous la forme d'une surface 95' avec des ondulations souvent appelées « scallops » avec des pics 96 comme illustré sur la partie gauche de la figure 1h. En fait, lors d'une gravure DRIE, on alterne entre une phase de gravure du silicium et une phase de passivation ce qui résulte en la surface ondulée 95'. Après une gravure DRIE ou un autre type de gravure, la rugosité des surfaces 95 peut être réduite par une étape de lissage, ce qui renforce ces surfaces mécaniquement en limitant les amorces de rupture. Ce lissage peut notamment être effectué par une étape d'oxydation thermique (typiquement dans un four) suivie par une étape de désoxydation, constituée par exemple d'une gravure par voie humide ou en phase vapeur à base d'acide fluorhydrique (HF). De manière connue, lors de l'oxydation thermique, le silicium à la surface 95 est consommée, et cette consommation est généralement plus rapide vers les pics 96, ce qui résulte en une surface de silicium plus lisse après la désoxydation.

Comme illustré à la figure 1n, les composants horlogers 90 dans la couche simple structurée amincie 30" sont libres et ne sont supportés structurellement que par des ponts de liaison dans cette couche afin que les composants 90 restent attachés aux parties subsistantes de cette couche. Un tel pont est illustré schématiquement en trait à 32 dans la figure 1n, mais en réalité le pont s'étend sur toute l'épaisseur du composant (voire sur toute l'épaisseur de la couche simple structurée amincie 30"). Il est alors possible par la suite d'effectuer des étapes de fabrication subséquentes sur la quasi-totalité de la surface externe des composants horlogers 90 formées dans la couche simple structurée amincie 30".

Les étapes subséquentes peuvent par exemple comprendre un autre jeu d'étapes d'oxydation (figure 1o) et de désoxydation (figure 1p) pour lisser encore les surfaces des composants horlogers et/ou pour ajuster les dimensions des composants. Un tel ajustement peut notamment être employé pour corriger la raideur quand les composants sont des spiraux ou des résonateurs. Une étape d'oxydation sans désoxydation (ou sans désoxydation complète) est également possible pour former une couche externe d'oxyde de silicium permanente sur les composants. Dans le cadre d'un spiral ou d'un autre type de résonateur horloger, une telle couche d'oxyde permanente compense les variations du module d'Young de l'âme en silicium du composant horloger en fonction de la température. Par ailleurs, la formation d'une telle couche externe d'oxyde de silicium sur les composants horlogers de n'importe quel type peut également servir à renforcer ces composants mécaniquement. D'autres types de matériaux peuvent également être formés sur les composants horlogers 90, par exemple par un dépôt type ALD. Il est également possible d'effectuer une étape de pré-assemblage ou d'usinage des composants horlogers 90 lorsqu'ils sont toujours attachés à la couche simple structurée amincie 30", comme par exemple pour assembler le composant à un axe, un tigeron, un piton ou une virole.

Comme expliqué ci-dessous, chaque étape d'oxydation thermique sert à réduire légèrement les dimensions de l'âme en silicium des composants horlogers, et pour cette raison l'épaisseur maximale final de l'âme des composants après toutes les étapes de fabrication peut être légèrement moins importante que l'épaisseur maximale e₉₀.

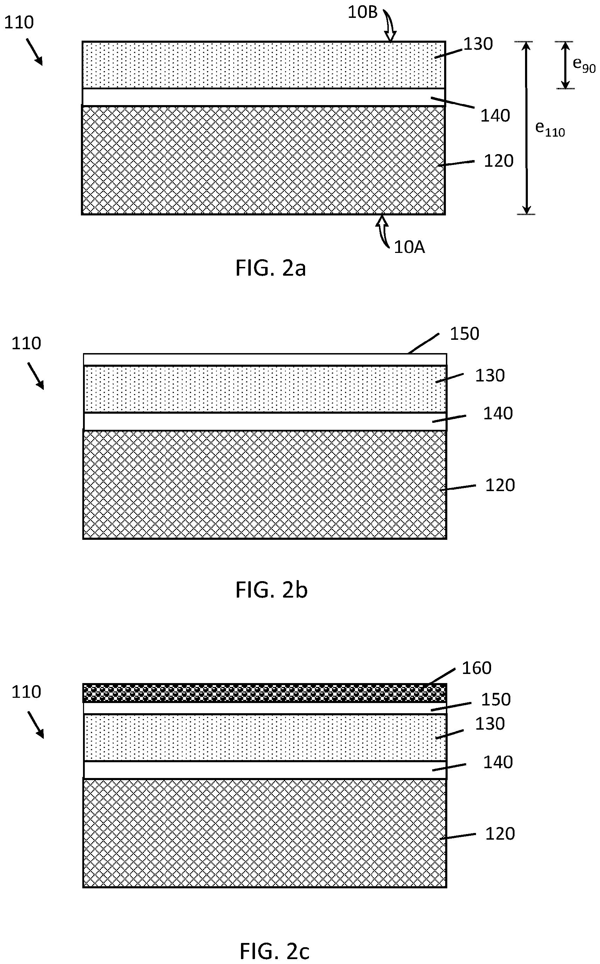

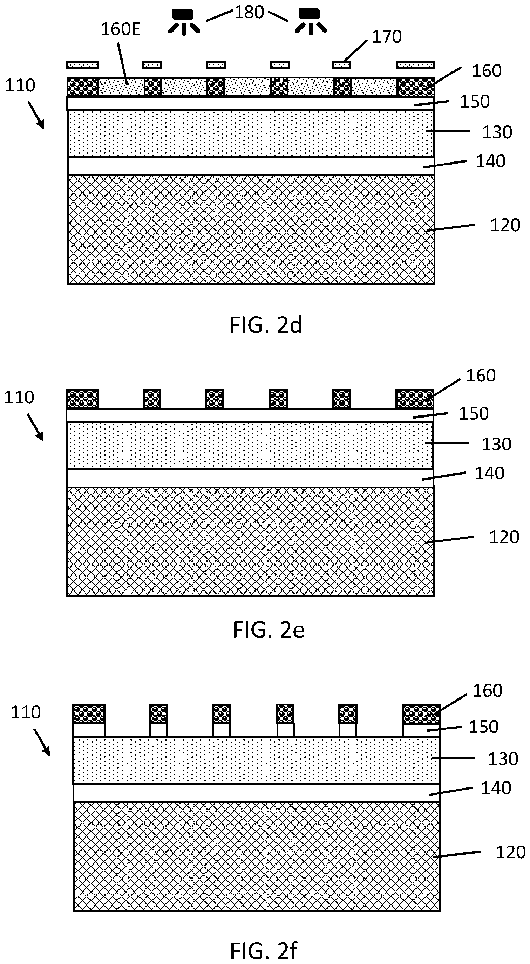

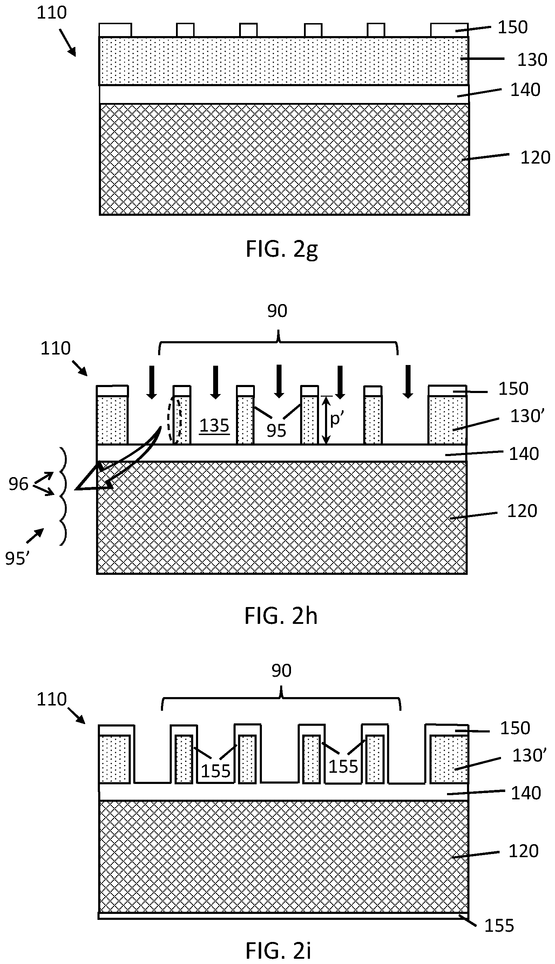

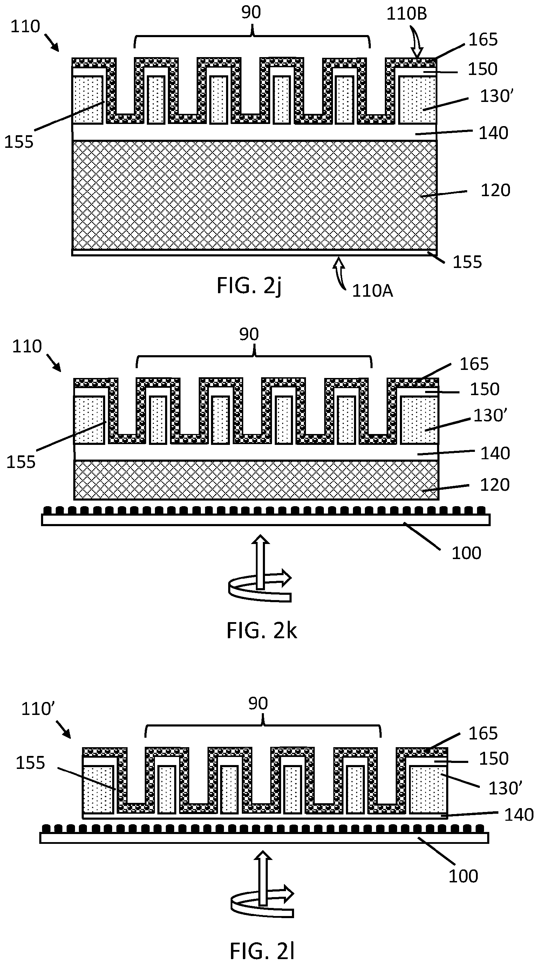

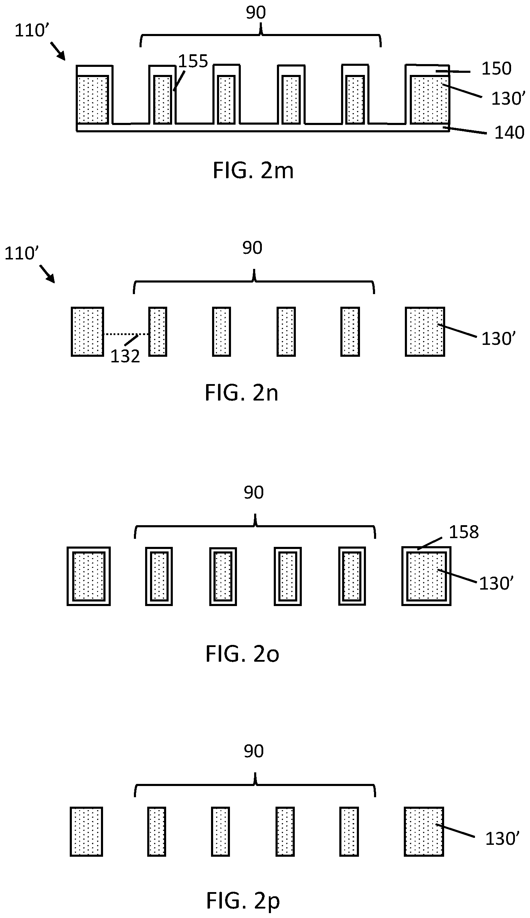

Les figures 2a-2p illustrent une série d'étapes de fabrication schématiques d'un composant horloger dans une plaquette SOI 110 selon un second mode de réalisation de l'invention. Encore une fois, plusieurs composants horlogers peuvent être fabriqués dans la plaquette 110 en même temps, mais les vues de la figure 2 sont isolées sur un seul composant pour des raisons de simplicité. Le procédé commence avec une plaquette SOI 110 illustrée à la figure 2a, cette plaquette comprenant une couche de support 120, une couche de travail 130 en silicium, et une couche d'oxyde enterrée 140 séparant les deux couches de silicium 120, 130 qui est typiquement et de préférence en oxyde de silicium (SiO₂). La couche de support 120 peut être en silicium ou en un autre matériau. Dans ce mode de réalisation, la plaquette SOI 110 a une épaisseur initiale e₁₁₀ qui est plus importante que l'épaisseur maximale finale e₉₀ des composants horlogers. Le dessin n'est pas à l'échelle, mais à titre d'exemple, la couche de support 120 peut avoir une épaisseur de 500 µm, la couche de travail 130 peut avoir une épaisseur de 120 µm, et la couche d'oxyde enterrée 140 peut avoir une épaisseur de 0.5-10 µm. De préférence, l'épaisseur de la couche de travail 130 correspond à l'épaisseur maximale e₉₀ des composants horlogers, mais selon des variantes l'épaisseur de la couche de travail 130 peut être plus importante que cette épaisseur maximale e₉₀. La plaquette SOI 110 comprend un côté inférieur 110A (voire le côté couche de support 120), et c'est depuis ce côté que la plaquette 110 repose normalement sur des équipements lors des différents étapes de microfabrication. La plaquette 110 comprend également un côté supérieur 110B (voire le côté couche de travail 130), et c'est depuis ce côté que les étapes de microfabrication pour former les composants horlogers sont généralement effectuées.

Si la couche de support 120 est en silicium, les couches de support et de travail peuvent être du même type de silicium ou de types différents - par exemple de silicium monocristallin avec une orientation cristalline quelconque, du silicium polycristallin, ou du silicium amorphe. Les couches de silicium 120, 130 et notamment la couche de travail 130 peuvent être dopés type N ou type P. Par exemple, l'utilisation d'un silicium fortement dopé peut être avantageuse pour la fabrication des résonateurs car, par exemple, on constate une déformation moindre de la matière dopée lors de l'oxydation thermique sous certaines conditions.

Dans la figure 2b, une étape de lithographie commence avec la formation d'une couche d'oxyde de silicium 150 sur la surface supérieure de la couche de travail 130. Par « lithographie », on entend l'ensemble des opérations permettant de transférer une image ou un motif sur ou au-dessus de la plaquette 110 vers cette dernière. La couche d'oxyde 150 peut par exemple avoir une épaisseur comprise entre 0.4 - 6 µm, et elle peut être formée par oxydation thermique ou alternativement par un dépôt de type PVD, CVD, ou ALD. Si la couche d'oxyde 150 est formée par un procédé de dépôt directionnel tel que le CVD ou le PVD, l'oxyde se forme uniquement sur la surface supérieure de la couche de travail, tel qu'illustré à la figure 2b. Alternativement, si la couche d'oxyde 150 est formée par oxydation thermique, on remarque que l'oxyde 150 se forme généralement en même temps sur la surface de la couche de support 120 (si cette dernière n'est pas couverte par un masque d'épargne) ou encore un second dépôt directionnel de type CVD ou PVD peut être effectué sur la surface de la couche de support 120. De manière générale, la formation de la couche d'oxyde 150 avant le dépôt d'une couche de résine (voir la figure 2c) permet de déposer une couche de résine relativement fine et uniforme avec une bonne homogénéité de surface et ainsi d'optimiser la gravure subséquente de motifs fins et profonds dans la couche de travail 130. Cependant, dans d'autres modes de réalisation, il est également possible de réaliser une étape de lithographie sans la couche d'oxyde, notamment en utilisant une résine photosensible plus épaisse.

A la figure 2c, la couche d'oxyde 150 est recouverte d'une couche de résine 160, qui est typiquement une résine photosensible de type positif ou négatif. Cette couche de résine peut avoir une épaisseur comprise entre 0.5 - 12 µm, à titre purement illustratif. Par la suite, dans la figure 2d, la couche de résine 160 est structurée de préférence en utilisant une étape de photolithographie avec une source de lumière ultraviolette 180 ainsi que, par exemple, un masque d'exposition 170 tel qu'un photomasque. Un système de stepper et réticule peut également être utilisé pour l'étape de photolithographie. Dans l'exemple illustré, la couche 160 comprend une résine photosensible de type positif dont les parties 160E de la résine qui sont exposées à la lumière deviennent solubles dans un révélateur et les parties non exposées restent insolubles. Selon d'autres modes de réalisation, la résine peut être structurée par un faisceau laser ou d'électrons.

Dans la figure 2e, la couche de résine 160 est ouverte après avoir été développée par un révélateur, notamment un solvant qui élimine les parties exposées 160E de la résine par voie chimique. Ensuite, à la figure 2f, les parties de la couche oxyde 150 qui se trouvaient en dessous des parties exposées 160E de la résine sont aussi retirées de la surface de la couche de travail 130, par exemple en employant une gravure plasma sélective avec les gaz CH₄/O₂. L'utilisation d'une technique de gravure directionnelle est généralement privilégiée lors de cette étape car elle est plus précise, mais alternativement une gravure à base de vapeur d'acide fluorhydrique (HF) peut aussi être utilisée.

A l'étape illustrée à la figure 2g, la partie restante de la couche de résine 160 est éliminée et ensuite, à l'étape de la figure 2h, des motifs séparés par des tranchées 135 sont gravés dans la couche de travail 130 au travers de la couche 150 structurée pour former le composant horloger 90 dans une couche de travail structurée 130'. De préférence dans ce mode de réalisation, les motifs gravés et donc les tranchées 135 s'étendent sur toute l'épaisseur de la couche de travail 130 tel qu'illustré, et à cette fin la couche d'oxyde enterrée 140 peut agir comme une couche d'arrêt lors de la gravure. Dans ce cas, l'épaisseur maximale e₉₀ des composants horlogers 90 correspond à l'épaisseur de la couche de travail structurée 130'.

La gravure à l'étape de la figure 1h peut notamment être effectuée par une technique de gravure ionique réactive profonde (également connue sous l'acronyme DRIE pour « Deep Reactive Ion Etching » en anglais). La gravure DRIE permet d'usiner des trous et des tranchées profondes dans la couche 130 avec un rapport largeur/hauteur important, ce qui est bien adapté pour des composants micromécaniques comme des composants horlogers. Alternativement, la structuration de la couche de support peut être réalisée par d'autres technologies de gravure telles qu'une opération de gravure humide/chimique anisotrope, par exemple en utilisant un bain d'hydroxyde de potassium (KOH) ou d'hydroxyde de tétraméthylammonium (TMAH). Une structuration par gravure humide/chimique peut notamment être plus rapide qu'une gravure ionique réactive profonde, mais la résolution dimensionnelle des structures gravées est généralement moins bonne. Si une opération de gravure humide/chimique anisotrope est employée, la couche d'oxyde 150 n'est normalement pas formée sur la surface supérieure de la couche de support 120 avant le dépôt de la résine 160 sur cette surface.

Il est également possible pour la partie restante de la couche de résine 160 d'être toujours présente lors de l'étape de gravure (DRIE ou autre) de la couche de travail 130. Cette partie restante de la couche de résine peut être retirée après la gravure, et dans ce cas la couche de travail 130 est gravée au travers des deux couches 150, 160 structurées (ou seulement à travers la couche 160 structurée si une couche oxyde 150 n'est pas présente). A titre d'exemple, une résine positive peut être retirée par des solvants de type acétone ou diméthylsulfoxyde (DMSO) ou avec un plasma O₂, soit avant soit après l'étape de gravure. Pour une résine négative comme le SU-8, un plasma CF₄/O₂ peut être employé pour son retrait.

Par la suite, à la figure 2i, une couche d'oxyde 155 de silicium (SiO₂) est de préférence formée sur au moins une partie des surfaces des flancs 95 du composant horloger et de préférence sur l'ensemble de chacune de ses surfaces. La couche d'oxyde 155 peut être formée par un dépôt de type PVD, CVD, ou ALD, mais de préférence elle est formée par oxydation thermique, et dans ce cas la couche d'oxyde 155 est formée également sur tout le silicium exposé de la plaquette 110 incluant la surface inferieure de la couche de support 120. L'épaisseur de cette couche d'oxyde 155 peut varier mais de préférence elle est d'au moins 0.05 µm. Par ailleurs, la couche d'oxyde 155 rejoint les couches d'oxydes 150 et 140 déjà présentes sur les surfaces supérieure et inférieure du composant horloger 90, et ces dernières couches peuvent aussi devenir plus épaisses si le dépôt de cette étape est effectué par oxydation thermique. Selon une variante, la couche d'oxyde 150 peut être éliminée après l'étape de gravure à la figure 1h, et dans ce cas la couche d'oxyde 155 se forme également sur la surface supérieure des composants horlogers 90 lors de l'étape de la figure 2i.

A une étape suivante illustrée à la figure 2j, la surface supérieure de la couche de travail structurée 130' et donc les composants 90 formés dans cette couche (qui sont déjà recouverts par les couches d'oxydes 150, 155) sont optionnellement recouverts, du moins en partie, d'une couche de résine 165. Le dépôt de la résine 165 est de préférence effectué par un revêtement par pulvérisation (en anglais « spray coating ») mais il peut également être réalisé par un trempage (an anglais « dip coating »), par une enduction par centrifugation (en anglais « spin coating »), ou par un dépôt sous vide avec de la poudre. Selon une variante, la formation de l'oxyde 155 à l'étape de la figure 1i peut également être écartée, et la résine 165 peut être déposée directement sur la couche de travail structurée 130' (avec ou sans la couche d'oxyde 150) après l'étape de la figure 2h.

Le procédé de fabrication de ce second mode de réalisation continue aux figures 2k et 2l avec une étape de nivellement mécanique qui sert à éliminer une partie de la plaquette 110 par un amincissement (voire une réduction) de l'épaisseur de la plaquette 110 depuis son côté inferieur 110A. Dans ce mode de réalisation, le nivellement mécanique sert notamment à éliminer au moins l'ensemble de la couche de support 120 de la plaquette. Comme décrit en plus de détails ci-dessous, ce nivellement mécanique est effectué depuis le côté inférieur 110A de la plaquette 110 et peut par exemple être réalisé encore une fois par le dispositif de meulage 100 qui sert à réduire l'épaisseur de la plaquette 110 de manière uniforme et contrôlée et, par exemple, avec une variation d'épaisseur de ± 1 µm. La figure 2k montre l'étape de nivellement mécanique en cours où le dispositif de meulage a déjà enlevé une partie de l'épaisseur de la couche de support 120 ainsi que toute la couche d'oxyde 155 sur la surface inferieure de cette couche si elle est présente. Dans la figure 2l, l'étape de nivellement mécanique prend fin quand la totalité de la couche de support 120 ainsi, éventuellement, qu'au moins une partie de la couche d'oxyde enterrée 140 ont été éliminées. A la fin de l'étape de nivellement mécanique, il en résulte alors une plaquette amincie 110' comprenant la couche de travail structurée 130' (avec les couches 150,155, 165 formées sur cette dernière) ainsi éventuellement qu'au moins une partie de de la couche d'oxyde enterrée 140.

Dans le mode de réalisation de la figure 2, la présence d'au moins une partie de la couche d'oxyde enterrée 140 en dessous de la couche de travail structurée 130' permet de protéger les composants horlogers 90 lors de l'étape de nivellement mécanique, et on peut arrêter le nivellement mécanique une fois que le nivellement a atteint la couche 140. Pour s'assurer qu'au moins une partie de la couche d'oxyde enterrée 140 est toujours présente sur la plaquette 110 après l'étape de nivellement mécanique, il peut être avantageux d'employer une couche d'oxyde enterrée 140 relativement épaisse dans la plaquette 110, par exemple avec une épaisseur supérieure à 2 µm et de préférence supérieure à 5 µm. Dans ce mode de réalisation, la couche de travail structurée 130' ne subit aucun nivellement mécanique, car son épaisseur correspond (du moins sensiblement) à l'épaisseur maximale voulue e₉₀ des composants horlogers 90. Cependant, dans une variante, la couche de travail peut avoir une épaisseur plus importante que l'épaisseur maximale voulue e₉₀ des composants. Dans ce cas, les motifs gravés dans la couche de travail sont séparés par des tranchées 135 ayant une profondeur p plus importante que l'épaisseur maximum e₉₀ des composants horlogers. Les motifs et les tranchées 135 s'étendent de préférence toujours sur toute l'épaisseur de la couche de travail, mais il est également possible que les motifs gravés et les tranchées ne s'étendent pas sur toute l'épaisseur de la couche de travail. Selon cette variante, l'étape de nivellement mécanique est également effectuée à travers toute la couche d'oxyde enterrée 140 et, à l'instar du premier mode de réalisation de la figure 1, sur une partie de la couche de travail structurée 130' jusqu'au niveau où son épaisseur est égale à l'épaisseur maximale e₉₀ des composants horlogers. Dans ce dernier cas, après l'étape de nivellement mécanique, les composants horlogers se trouvent alors dans une couche de travail structurée amincie.

Selon une autre variante, l'étape de nivellement mécanique peut avoir lieu immédiatement après l'étape de gravure de la figure 2h, mais de préférence les couches 155 et/ou 165 sont formées après la gravure afin de protéger elles aussi les composants horlogers lors de l'étape de nivellement mécanique. Quand les couches 155 et/ou 165 sont formées tel que décrit ci-dessus en lien avec les figures 2i et 2j, la couche de résine 165 est éliminée après l'étape de nivellement mécanique comme illustré à la figure 2m et par la suite, à la figure 2n, on effectue une désoxydation pour éliminer les couches d'oxydes 140, 150 et 155 autour des composants horlogers 90. Cette étape de désoxydation est de préférence réalisée par une gravure par voie humide ou en phase vapeur à base d'acide fluorhydrique (HF). Comme dans le premier mode de réalisation, la formation de la couche d'oxyde 155 par oxydation thermique à la figure 2i peut aussi faire partie d'une étape de lissage des composants horlogers 90 en combinaison avec l'étape de désoxydation à la figure 2n.

Après les étapes décrites ci-dessus, les composants horlogers 90 dans la couche de travail structurée (qui est éventuellement amincie également) sont libres et ne sont supportés structurellement que par des ponts de liaison dans cette couche afin que les composants 90 restent attachés aux parties subsistantes de cette couche. Un tel pont est illustré schématiquement en trait à 132 dans la figure 2n, mais en réalité le pont s'étend sur toute l'épaisseur du composant (voire sur toute l'épaisseur de la couche de travail structurée 30"). Il est alors possible par la suite d'effectuer des étapes de fabrication subséquentes sur la quasi-totalité de la surface externe des composants horlogers 90 formées dans la couche de travail structurée 130'.

Les étapes subséquentes peuvent par exemple comprendre un autre jeu d'étapes d'oxydation (figure 2o) et de désoxydation (figure 2p) pour lisser encore les surfaces des composants horlogers et/ou pour ajuster les dimensions des composants. Un tel ajustement peut notamment être employé pour corriger la raideur quand les composants sont des spiraux ou des résonateurs. Une étape d'oxydation sans désoxydation (ou sans désoxydation complète) est également possible pour former une couche externe d'oxyde de silicium permanente sur les composants. Dans le cadre d'un spiral ou d'un autre type de résonateur horloger, une telle couche d'oxyde permanente compense les variations du module d'Young de l'âme en silicium du composant horloger en fonction de la température. Par ailleurs, la formation d'une telle couche externe d'oxyde de silicium sur les composants horlogers de n'importe quel type peut également servir à renforcer ces composants mécaniquement. D'autres types de matériaux peuvent également être formés sur les composants horlogers 90, par exemple par un dépôt type ALD. Il est également possible d'effectuer une étape de pré-assemblage ou d'usinage des composants horlogers 90 lorsqu'ils sont toujours attachés à la couche simple structurée amincie 30", comme par exemple pour assembler le composant à un axe, un tigeron, un piton ou une virole.

Comme expliqué ci-dessous, chaque étape d'oxydation thermique sert à réduire légèrement les dimensions de l'âme en silicium des composants horlogers, et pour cette raison l'épaisseur maximale final de l'âme des composants après toutes les étapes de fabrication peut être légèrement moins importante que l'épaisseur maximale e₉₀.

Comme indiqué ci-dessus, l'étape de nivellement mécanique est de préférence réalisée par un dispositif de meulage, mais il est également possible d'utiliser d'autres techniques de nivellement mécanique telles que le polissage, le sablage, la rectification ou la découpe. De préférence, un ruban adhésif (non illustré) sensible à la lumière ultraviolette (UV) est appliqué sur la surface supérieure de la plaquette 10, 110 (voire depuis son côté supérieure 10B, 110B) avant l'étape de nivellement mécanique. Ce ruban sert à protéger les composants horlogers lors du nivellement mécanique, et peut être enlevé par irradiation de lumière ultraviolette par la suite. Un renfort mécanique peut également être appliqué sur la surface supérieure de la plaquette pendant l'étape de nivellement mécanique pour maintenir la plaquette.

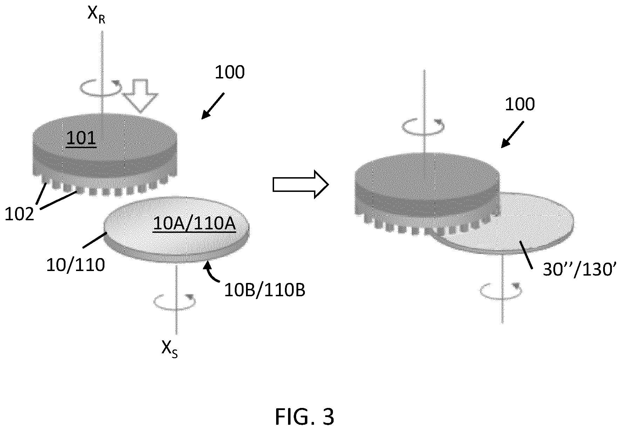

La figure 3 illustre à titre d'exemple un dispositif de meulage 100 qui peut être employé lors de l'étape de nivellement dans les différents modes de réalisation décrits ci-dessus. Le dispositif de meulage comprend un support (non illustré) sur lequel la plaquette 10, 110 est montée et une roue de meulage 101 portant des organes d'abrasion 102 qui agissent contre la plaquette sur le support. La roue 101 et le support sont mobiles en rotation l'un par rapport à l'autre, et les organes d'abrasion 102 peuvent par exemple être en diamant ou en corindon ou revêtus de diamant. On monte la plaquette 10, 110 dans le dispositif de meulage 100 en mettant la surface supérieure de la plaquette 10, 110 (qui est de préférence recouverte du ruban adhésif) contre le support. La plaquette 10, 110 peut être maintenue en position sur le support par des moyens de retenu appropriés. De préférence, la roue 101 est mobile en rotation autour d'un axe X_{R} et le support est également mobile en rotation atour d'un axe X_{S} parallèle à l'axe X_{R}, mais il peut suffire si au moins un parmi le support et la roue est mobile en rotation. Au moins un parmi la roue 101 et le support est également mobile axialement afin que les organes d'abrasion 102 de la roue puissent agir de manière contrôlée contre la surface de la plaquette 10, 110 depuis son côté inferieur 10A, 110A. La réduction en épaisseur des plaquettes peut être réalisée en plusieurs phases en utilisant différentes roues de meulage avec des organes plus ou moins abrasifs et en variant la vitesse de rotation de la roue 101 et/ou du support. En particulier, de préférence on ralentit la vitesse de rotation quand on s'approche à l'épaisseur ciblée de la plaquette. Il est également possible d'arrêter l'étape de nivellement mécanique à différents moments et d'effectuer une ou plusieurs mesures intermédiaires de l'épaisseur actuelle de la plaquette pour vérifier le taux de réduction de l'épaisseur et ajuster, si nécessaire, les paramètres de l'étape afin de bien arriver à l'épaisseur ciblée de la plaquette. De l'eau peut être utilisée pour nettoyer la plaquette lors du meulage.

Une fois que le meulage (ou une autre technique de nivellement mécanique) de la plaquette est fini et on arrive à l'épaisseur ciblée, on peut optionnellement effectuer une étape complémentaire de polissage plat (aussi appelé poli-bloqué) pour réduire la rugosité de la surface nivelée de la plaquette. Si un ruban adhésif a été utilisé, il est de préférence enlevé par irradiation UV, et par la suite la plaquette peut être dépolluée dans une machine de nettoyage qui élimine des contaminations et des résidus par voie sèche, humide ou plasma.

A titre d'exemple, la machine DA810 fournie par la société Disco Corporation peut être utilisée pour le meulage, la polisseuse M.M.8600 fournie par la société LAM PLAN S.A.S peut être utilisée pour le polissage plat, et la machine DCS1440 de Disco Corporation peut être utilisée pour nettoyer les plaquettes après le meulage. La machine DA810 permet d'effectuer le meulage avec une variation d'épaisseur (TTV ou « Total Thickness Variation » en anglais) de ± 1 µm et des vitesses allant jusqu'à 30 µm/minute.

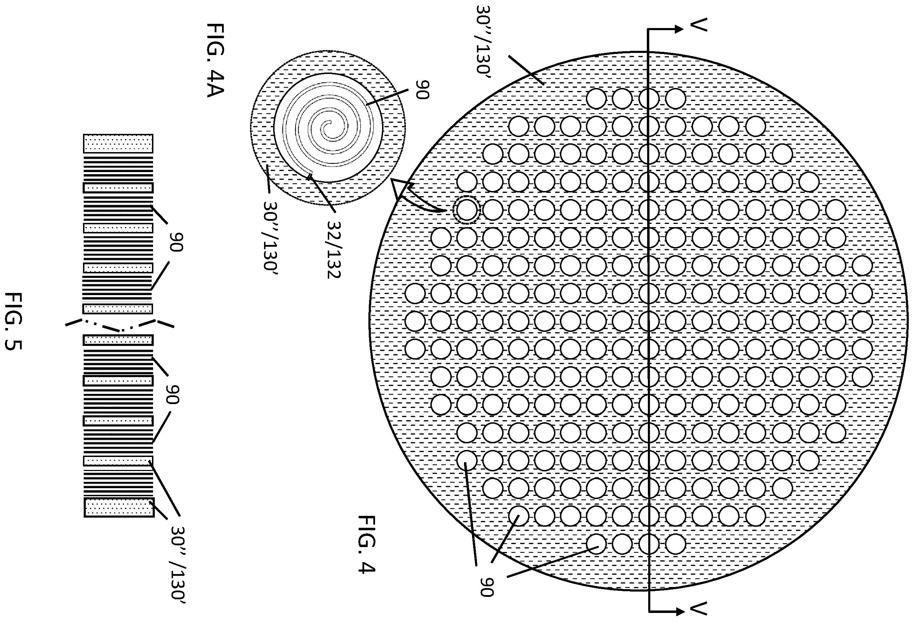

La figure 4 est une vue de dessus de, soit la couche simple structurée amincie 30" après les étapes de fabrication des figures 1a-1n selon le premier mode de réalisation, soit la couche de travail structurée 130' après les étapes de fabrication des figures 2a-2n selon le second mode de réalisation. A noter que dans la figure 4, les composants horlogers 90 se trouvent dans des zones de la couche qui sont simplement illustrés par des cercles vides afin de ne pas surcharger le dessin, mais la figure 4A donne une vue agrandie d'une de ces zones montrant à titre d'exemple un spiral comme le composant horloger et son pont de liaison 32 ou 132. De préférence, les ponts de liaison 32, 132 ont une largeur suffisante pour bien résister à un détachement des composants lors de l'étape de nivellement mécanique incluant toute étape d'irradiation UV pour enlever le ruban adhésif. A titre d'exemple, les ponts de liaison 32, 132 ont de préférence une largeur d'au moins 5 µm. La figure 5 est également une vue en section selon la ligne V-V de la figure 4 montrant plusieurs composants horlogers 90 dans, soit la couche simple structurée amincie 30" du premier mode de réalisation, soit la couche de travail structurée 130' du second mode de réalisation.

Les différentes étapes d'oxydation mentionnées ci-dessus peuvent être réalisées en plaçant la plaquette 10 ou 110 dans un four à une température comprise entre 800°C et 1200°C et dans une atmosphère oxydante comprenant par exemple de la vapeur d'eau ou du dioxygène gazeux (O₂). L'épaisseur de la couche d'oxyde formée dépend de manière connue de la durée de l'étape d'oxydation.

Une fois que les étapes de fabrication des composants horlogers 90 telle que décrites ci-dessus sont complétées, les composants horlogers peuvent être détachés individuellement et par la suite assemblé et monté chacun dans une pièce d'horlogerie, par exemple dans un oscillateur ou dans un mécanisme d'échappement d'un mouvement horloger mécanique.

La présente invention n'est pas limitée aux modes de réalisation et variantes présentés et d'autres modes de réalisation et variantes apparaîtront clairement à l'homme du métier. Ainsi, les réalisations ci-dessus sont des exemples. Bien que la description se réfère à un ou plusieurs modes de réalisation et leurs variantes, ceci ne signifie pas nécessairement que chaque référence concerne le même mode de réalisation ou variante, ou que les caractéristiques s'appliquent seulement à un seul mode de réalisation ou variante. De simples caractéristiques de différents modes de réalisation et leurs variantes peuvent également être combinées et/ou interchangées pour fournir d'autres réalisations.

## Revendications

1. Procédé de fabrication d'une pluralité de composants horlogers (90) en silicium dans une plaquette, le procédé comprenant les étapes suivantes :
(a) se doter d'une plaquette (10, 110), ayant un côté inférieur (10A, 110A), un côté supérieur (10B, 110B) et une épaisseur initiale, l'épaisseur initiale de la plaquette (e₃₀, e₁₁₀) étant plus importante qu'une épaisseur maximale des composants horlogers (e₉₀) à fabriquer, ladite plaquette comprenant au moins une couche en silicium (30, 130) pour former les composants horlogers (90);
(b) former les composants horlogers (90) en gravant des motifs dans la couche en silicium (30, 30', 130, 130') depuis le côté supérieur (10B, 110B) de la plaquette (10, 110) ; et
(c) effectuer un nivellement mécanique depuis le côté inferieur (10A, 110A) de la plaquette (10, 110) pour éliminer une partie de la plaquette (10, 110) par un amincissement de l'épaisseur de ladite plaquette (10, 110).

2. Procédé selon la revendication 1, dans lequel la plaquette (10) comprend une couche simple en silicium (30) sans couche de support, la couche simple (30) ayant une épaisseur (e₃₀) qui est plus importante que l'épaisseur maximale (e₉₀) des composants horlogers, et dans lequel le nivellement mécanique à l'étape (c) élimine une partie de la couche simple (30, 30').

3. Procédé selon la revendication 2, dans lequel après le nivellement mécanique à l'étape (c) l'épaisseur de la couche simple (30, 30', 30") est sensiblement égale à l'épaisseur maximale (e₉₀) des composants horlogers.

4. Procédé selon la revendication 2 ou 3, dans lequel les motifs gravés dans la couche simple (30) ne s'étendent pas sur toute l'épaisseur (e₃₀) de la couche simple (30), lesdites motifs étant séparés par des tranchées (35) ayant une profondeur (p) plus importante que l'épaisseur maximum (e₉₀) des composants horlogers (90).

5. Procédé selon la revendication 1, dans lequel la plaquette est une plaquette de type SOI (110) comprenant une couche de support (120), une couche de travail (130) en silicium dans laquelle les composants horlogers (90) sont formés, et une couche d'oxyde enterrée (140), de préférence en oxyde de silicium, séparant la couche de support (120) de la couche de travail (130).

6. Procédé selon la revendication 5, dans lequel le nivellement mécanique à l'étape (c) élimine au moins l'ensemble de la couche de support (120) de la plaquette (110).

7. Procédé selon la revendication 5 ou 6, dans lequel la couche de travail (130) a une épaisseur qui est sensiblement égale à l'épaisseur maximale (e₉₀) des composants horlogers (90), les motifs gravés dans la couche de travail (130) s'étendant sur toute son épaisseur.

8. Procédé selon la revendication 7, dans lequel au moins une partie de ladite couche d'oxyde enterrée (140) est toujours présente sur la plaquette (110) après l'étape (c) de nivellement mécanique.

9. Procédé selon la revendication 5 ou 6, dans lequel la couche de travail (130) a une épaisseur qui est plus importante que l'épaisseur maximale (e₉₀) des composants horlogers (90), et les motifs sont séparés par des tranchées (135) ayant une profondeur (p') plus importante que l'épaisseur maximum (e₉₀) des composants horlogers (90), dans lequel le nivellement mécanique à l'étape (c) élimine une partie de la couche de travail (130, 130'), et dans lequel après le nivellement mécanique à l'étape (c) l'épaisseur de la couche de travail (130, 130') est sensiblement égale à l'épaisseur maximale (e₉₀) des composants horlogers.

10. Procédé selon l'une des revendications précédentes, dans lequel une couche d'oxyde de silicium (50, 55, 150, 155) est formée sur au moins une partie des surfaces des composants horlogers (90) avant le nivellement mécanique de l'étape (c).

11. Procédé selon l'une des revendications précédentes, dans lequel une couche de résine (65, 165) est formée sur au moins une partie des surfaces des composants horlogers (90) avant le nivellement mécanique de l'étape (c).

12. Procédé selon l'une des revendications précédentes, dans lequel on réalise le nivellement mécanique à l'étape (c) avec un dispositif de meulage (100).

13. Procédé selon la revendication 12, dans lequel le dispositif de meulage (100) comprend un support sur lequel la plaquette (10, 110) est destinée à être montée et une roue de meulage portant des organes d'abrasion (102), le support et la roue (101) étant mobiles en rotation l'un par rapport à l'autre, l'étape (c) de nivellement mécanique comprenant les étapes de :
- monter la plaquette (10, 110) dans le dispositif de meulage (100) en mettant une surface supérieure de la plaquette (10, 110) contre le support ; et
- mettre la roue (101) et/ou le support en rotation afin que les organes d'abrasion (102) de la roue (101) agissent de manière contrôlée contre la surface de la plaquette (10, 110) depuis son côté inferieur (10A, 110A).

14. Procédé selon l'une des revendications 1 à 11, dans lequel on réalise le nivellement mécanique à l'étape (c) par des moyens de polissage, de sablage, de rectification et/ou de découpe.

15. Procédé selon l'une des revendications précédentes, comprenant les étapes
- d'appliquer un ruban adhésif sensible à la lumière ultraviolette sur une surface supérieure de la plaquette (10, 110) avant l'étape (c) de nivellement mécanique, et
- irradier ladite surface supérieure de la plaquette (10, 110) avec la lumière ultraviolette après l'étape (c) de nivellement mécanique afin d'enlever le ruban adhésif.

16. Procédé selon l'une des revendications précédentes, après la formation des composants horlogers (90) à l'étape (b), les composants horlogers (90) sont supportés structurellement par des ponts de liaison (32, 132) qui les maintiennent attachés aux parties subsistantes de la couche en silicium, les ponts de liaison (32, 132) ayant une largeur d'au moins 5 µm.
